# EUROPÄISCHE PATENTSCHRIFT

(11) **EP 2 997 174 B1**
(45) Veröffentlichungstag und Bekanntmachung des Hinweises auf die Patenterteilung: **21.09.2016**
(21) Anmeldenummer: 15731384.2
(22) Anmeldetag: 29.06.2015
(51) Int. Cl.: C23C 14/06, C23C 14/16, G01T 3/00

(54) **VERFAHREN ZUR HERSTELLUNG VON NEUTRONENKONVERTERN**
METHOD FOR THE PRODUCTION OF NEUTRON CONVERTERS
PROCÉDÉ DE FABRICATION DE CONVERTISSEURS À NEUTRONS

(30) Priorität: 14.07.2014 EP 14176907
(43) Veröffentlichungstag der Anmeldung: 23.03.2016
(73) Patentinhaber: Helmholtz-Zentrum Geesthacht Zentrum für Material- und Küstenforschung GmbH, 21502 Geesthacht (DE)
(72) Erfinder: STÖRMER, Michael, 21031 Hamburg (DE); HORSTMANN, Christian, 21502 Geesthacht (DE); NOWAK, Gregor, 22117 Hamburg (DE); KAMPMANN, Reinhard, 21365 Adendorf (DE); HEDDE, John, 21403 Wendisch-Evern (DE)
(74) Vertreter: Uexküll & Stolberg
(86) Internationale Anmeldenummer: PCT/EP2015/064751
(87) Internationale Veröffentlichungsnummer: WO 2016/008713

(56) Entgegenhaltungen:
- SINIAWSKI M T ET AL: "Effects of Thickness and Roughness Variations on the Abrasiveness of a Thin Boron Carbide Coating", TRIBOLOGY LETTERS, KLUWER ACADEMIC PUBLISHERS-PLENUM PUBLISHERS, NE, Bd. 17, Nr. 4, 1. November 2004 (2004-11-01), Seiten 931-937, XP019292415, ISSN: 1573-2711
- HÖGLUND CARINA ET AL: "BC thin films for neutron detection", JOURNAL OF APPLIED PHYSICS, AMERICAN INSTITUTE OF PHYSICS, US, Bd. 111, Nr. 10, 15. Mai 2012 (2012-05-15) , Seiten 104908-104908, XP012157584, ISSN: 0021-8979, DOI: 10.1063/1.4718573 [gefunden am 2012-05-23]

## Beschreibung

Die vorliegende Erfindung betrifft ein Verfahren zur Herstellung von Neutronenkonvertern.

### HINTERGRUND DER ERFINDUNG

Neutronen werden heutzutage in der Grundlagenforschung und in der Charakterisierung biologischer und kondensierter Materie eingesetzt. Diese vielseitige Sonde ermöglicht, durch ihre inneren Eigenschaften zeit- und ortsaufgelöste Studien an Einkristallen, magnetischen Schichten, Polymer-Membranen insbesondere biologischen Zellen mittels Diffraktion, Reflektometrie, Kleinwinkelstreuung, Spektroskopie sowie Tomographie. Wenn die kinetische Energie der Neutronen durch Moderatoren und Selektoren auf thermische Energie gesenkt wird, dann entspricht die DeBroglie-Wellenlänge der Neutronen mit hinreichender Genauigkeit den atomaren Abständen in Festkörpern. Dadurch kann die Struktur eines Festkörpers durch Streuprozesse sehr genau untersucht werden. In niedrigen Energiebereichen ermöglichen Neutronen Rückschlüsse über interne Energiezustände des Festkörpers. Für diese Anwendung ist eine ortsaufgelöste Detektion der Neutronen notwendig.

Die üblicherweise eingesetzten Detektorsysteme nutzen das Gas ³He unter hohem Druck zum Nachweis der Neutronen. Diese haben eine hohe Nachweiseffizienz (bis zu 95%) bei einer geringen Zählratenakzeptanz. ³He-Zählrohre und sogenannte Multi-Wire Proportinal Chamber (MWPC)-³He-Gasdetektoren haben bestenfalls eine Ortsauflösung im mm-Bereich und werden für die Herstellung von homogenen und großflächigen Neutronendetektoren nur unter großem Aufwand eingesetzt. Diese Technologie ist allerdings Stand der Technik, da es bisher keine starken treibenden Kräfte zur Suche nach Alternativen gegeben hat.

Auf Grund der beschränkten Verfügbarkeit von ³He und dem wachsenden Bedarf an Neutronendetektoren ist in jüngerer Zeit die Forschung und Entwicklung von alternativen Detektormaterialien kontinuierlich gestiegen. Eine bekannte Alternative zu ³He-Gasdetektoren sind ¹⁰B-Festkörperdetektoren. Das Isotop ¹⁰B hat einen relativ großen Neutronenabsorptionsquerschitt, und damit verbunden eine Absorptionseffektivität von 70% im Vergleich zu dem des ³He-Isotops in einem breiten Energiebereich von 10⁻² bis 10⁴ eV; das entspricht einem Wellenlängenband von 0.286 nm bis 0.286 pm.

Der Einsatz von ¹⁰B-Festkörperdetektoren verspricht darüber hinaus eine Verbesserung in der Ortsauflösung der Neutronendetektion im Vergleich zum konventionellen ³He-Gasdetektor. Die ¹⁰B-Festkörperdetektoren können aus einer Unterlage (Substrat) oder einem ¹⁰B-haltigen Film bestehen:
Für die Realisierung könnten folgende Anforderungen für den Konverter (d.i. Schicht-Substrat-System) aufgestellt werden:
   - eine möglichst gute Haftung des Films auf dünnen Blechen (Substrat) aus einem neutronentransparenten Material wie Aluminium oder einer Aluminiumlegierung,
   - eine hohe Transmission des Substrats für thermische und karlte Neutronen,
   - eine gute Stabilität des Systems im Hinblick auf Strahlenbelastung und bei mechanischer sowie thermischer Beanspruchung.

Die Beschichtungen sollten zudem eine hohe Homogenität in Schichtdicke, chemischer Zusammensetzung und Isotopenverhältnis und möglichst wenig Verunreinigungen aufweisen. Eine hohe Quanteneffizienz der Konverterschichten für den Neutronennachweis bei Einstrahlung unter kleinen Winkeln zur Oberfläche ist ein weiteres Ziel der Erfindung. Generell sollten die ¹⁰B-enthaltende Beschichtungen für Festkörperdetektoren kostengünstig herstellbar sein.

Die US 6,771,730 offenbart einen Halbleiter-Neutronenkonverter mit einer Borkarbidschicht, die das Isotop ¹⁰B enthält. Das Borkarbid wurde durch plasmagestützte, chemische Gasphasenabscheidung, kurz PECVD, auf einer Siliziumhalbleiterschicht erzeugt.

Die WO 2013/002697 A1 beschreibt ein Verfahren zur Herstellung einer Neutronenkonverterkomponente, die eine Borkarbldschicht umfasst. Bei dem Verfahren wird das Borkarbid auf ein neutronentransparentes Substrat, ebenfalls mittels plasmagestützter, chemischer Gasphasenabscheidung aufgetragen.

Die bekannten Beschichtungen erfüllen allerdings nicht in allen Punkten die oben genannten Qualitäts- oder wirtschaftlichen Anforderungen, insbesondere, wenn große Bleche beschichtet werden sollen.

Zum Beispiel wird in C. Höglund et al. J. Appl. Phys. 111, 104908 (2012) eine verbesserte Haftung durch eine Temperaturbehandlung und Beschichtung mit hoher Rate realisiert. Für die verbesserte Haftung werden eine stärkere Schichtdickenvariation und höhere Herstellungskosten in Kauf genommen.

### ZUSAMMENFASSUNG DER ERFINDUNG

Der vorliegenden Erfindung liegt die Aufgabe zu Grunde, ein Verfahren zur Herstellung von Neutronenkonvertern zur Verfügung zu stellen, welches die oben beschriebenen Anforderungen an den Konverter (Film+Substrat) erfüllt: Insbesondere eine kontinuierliche, homogene Beschichtung eines ¹⁰B-haltigen Materials im Bereich von einigen Mikrometern aufzuweisen und eine sehr gute Haftung und hervorragende thermische und mechanische Stabilität unter lang andauernder Bestrahlung zu besitzen.

Diese Aufgabe wird durch ein Verfahren gemäß Patentanspruch 1 gelöst.

Erfindungsgemäß wird ein Metallsubstrat in einem ersten Schritt durch poliert und in einem weiteren Schritt mittels Sputtern (Kathodenstrahlzerstäuben) mit Borkarbid oder einem Borfilm beschichtet.

Das Feinschleifen findet bevorzugt unter Verwendung von Schleifpapieren statt, kann aber auch mit Hilfe einer Polierpaste - einer Emulsion aus Metallstaub, Schleifflüssigkeit und Schleifpapierkörnern - durchgeführt werden. Beim Schleifen werden die oberen Materialschichten mit Hilfe gebundener Schleifkörner (SiC, Al₂O₃, Diamant oder CBN) abgetragen. Die Körnung des verwendeten Schleifpapiers oder der Schleifpaste liegt bevorzugt im Bereich von 800 bis 2500, wobei man bei feiner werdender Körnung von Polieren spricht. Der metallografische Polierprozess beruht wie beim Schleifen auf dem spanabhebenden Abtragseffekt der Poliermedien, jedoch ist der Abrieb um einiges geringer als beim Schleifen, da mit sehr feinen Körnungen gearbeitet wird.

Bevorzugt wird das Metallsubstrat in aufeinanderfolgenden Schritten unter Verwendung von Schleifpapieren und/oder Schleifpasten mit aufsteigend feinerer Körnung zunächst feingeschliffen und dann poliert.

Bevorzugt werden zum Feinschleifen SiC- oder Al₂O₃-Papiere oder -Pasten verwendet.

Bei Verwendung eines Schleifpapiers findet das Feinschleifen bevorzugt auch unter Verwendung einer Schleifflüssigkeit als Naßschleifen statt. Vorzugsweise ist die Schleifflüssigkeit aus der Gruppe bestehend aus Aceton, einem Alkohol wie Methanol, Ethanol, Propanol oder Butanol, und Wasser ausgewählt. Bevorzugt wird Ethanol oder Wasser als Schleifflüssigkeit verwendet. Auch bei Verwendung einer Polierpaste ist die Schleifflüssigkeit bevorzugt aus der Gruppe bestehend aus Aceton, einem Alkohol wie Methanol, Ethanol, Propanol oder Butanol, und Wasser ausgewählt.

Das Metallsubstrat ist neutronentransparent und wird bevorzugt aus der Gruppe bestehend aus Aluminium oder einer Aluminiumlegierung, wie einer Titan-Aluminium-Legierung ausgewählt.

Nach dem Feinschleifen wird das Metallsubstrat vorzugsweise gespült. Anschließend kann das polierte und gegebenenfalls gespülte Metallsubstrat mit einer Haftvermittlerschicht, wie einer Titanschicht beschichtet werden. Bevorzugt wird die Haftvermittlerschicht durch Sputtern (Kathodenstrahlzerstäuben) erzeugt. Allerdings erzielt die Vorbehandlung eine Haftung zwischen Konverterschicht und Metallsubstrat, die eine Haftvermittlerschicht in den meisten Fällen entbehrlich macht.

Schließlich wird das Metallsubstrat mittels Kathodenstrahlzerstäuben (engl. sputtering) mit Borkarbid oder mit Borfilm beschichtet. Als Borkarbid wird bevorzugt mit ¹⁰B angereichertes B₄C verwendet. Die Beschichtung kann ohne oder mit einem Haftvermittler wie Titan durchgeführt werden. Die Schichtdicke der Beschichtung liegt bevorzugt im Bereich von 100 nm bis 10 µm, bevorzugter 250 nm bis 5 µm, am meisten bevorzugt 500 nm bis 3 µm.

Das Sputtern sowohl der Haftvermittlerschicht als auch der Konverterschicht wird bevorzugt. mit festen Magnetronsputterquellen durchgeführt, wobei die Substrate gegenüber den Kathoden bewegt werden, um eine großflächig homogene Beschichtung zu erzeugen. Vorzugsweise ist der Teilchenfluss horizontal orientiert, um Kontamination auf dem Substrat und dem Sputtertarget zu minimieren. Die Beschichtungsraten liegen vorzugsweise im Bereich von 0.1 bis 1.0 nm/s. Vorzugsweise findet die Beschichtung bei einem Argondruck statt, der so gering sein kann, wie 1 µbar. Weitere Details zu Beschichtungen und Methoden insbesondere dem Manetronsputtern finden sich in Milton Ohring, Materials Science of Thin Films, Academic Press, London 1992, auf das hier vollständig Bezug genommen wird.

Durch Anwendung des erfindungsgemäßen Verfahrens können Neutronenkonverter mit einer gleichmäßigen Beschichtungsfläche von bis zu mehreren Quadratmetern, wie im Bereich von 1 bis 100 m² hergestellt werden. Die in Versuchen hergestellten Schichten auf Metallsubstraten mit einer Beschichtungsfläche von 0,5 bis 1,0 m² wurden mittels eines speziell entwickelten Testdetektors charakterisiert. Es konnten hohe Quanteneffizienten nachgewiesen werden.

Die erhaltenen Beschichtungen weisen eine hohe Homogenität in Schichtdicke, chemischer Zusammensetzung und Isotopenverhältnis sowie geringe Verunreinigungen wie Sauerstoff oder Stickstoff auf. Überraschenderweise weisen die erfindungsgemäß hergestellten Beschichtungen eine gute Haftung auf dünnen Blechen aus Aluminium oder einer Aluminiumlegierung selbst bei großflächigen oder dicken Beschichtungen von bis zu 5 µm auf.

## Patentansprüche

1. Verfahren zur Herstellung von Neutronenkonvertern, bei dem ein neutronentransparentes Metallsubstrat aus Aluminium oder einer Aluminiumlegierung in einem ersten Schritt durch Feinschleifen poliert und in einem zweiten Schritt mit Borcarbid mittels Sputtern beschichtet wird.

2. Verfahren nach Anspruch 1, **dadurch gekennzeichnet, dass** das Feinschleifen unter Verwendung von Schleifpapieren stattfindet.

3. Verfahren nach Anspruch 2, **dadurch gekennzeichnet, dass** Schleifpapiere der Körnung im Bereich von 1000 bis 2500 verwendet werden.

4. Verfahren nach einem der Ansprüche 2 oder 3, **dadurch gekennzeichnet, dass** das Feinschleifen zusätzlich unter Verwendung einer Schleifflüssigkeit stattfindet.

5. Verfahren nach Anspruch 4, **dadurch gekennzeichnet, dass** die Schleifflüssigkeit aus der Gruppe bestehend aus Aceton, einem Alkohol und Wasser ausgewählt ist.

6. Verfahren nach Anspruch 5, **dadurch gekennzeichnet, dass** als Alkohol Ethanol verwendet wird.

7. Verfahren nach einem der vorgehenden Ansprüche, **dadurch gekennzeichnet, dass** das neutronentransparente Metallsubstrat aus Aluminium oder einer Titan-Aluminium-Legierung besteht.

8. Verfahren nach einem der vorgehenden Ansprüche, **dadurch gekennzeichnet, dass** mit ¹⁰B angereichertes B₄C als Borcarbid zum Beschichten verwendet wird.

9. Verfahren nach Anspruch 7, **dadurch gekennzeichnet, dass** das Borcarbid 95% ¹⁰B umfasst.

## Claims

1. Method for the manufacture of neutron converters, wherein a neutron transparent metal substrate of aluminium or a aluminium alloy is polished in a first step by fine grinding and coated in a second step by sputtering.

2. Method according to claim 1, **characterised in that** the fine grinding takes place using grinding papers.

3. Method according to claim 2, **characterised in that** grinding papers of a grain in the range of from 1000 - 2500 are used.

4. Method according to one of claims 2 or 3, **characterised in that** the fine grinding additionally takes place using a grinding liquid.

5. Method according to claim 4, **characterised in that** the grinding liquid is selected from the group consisting of acetone, an alcohol and water.

6. Method according to claim 5, **characterised in that** ethanol is used as alcohol.

7. Method according to one of the preceding claims, **characterised in that** the metal sheet consists of aluminium or a titanium-aluminium alloy.

8. Method according to one of the preceding claims, **characterised in that** B₄C enriched with ¹⁰B is used as boron carbide for coating.

9. Method according to claim 7, **characterised in that** the boron carbide has 95% ¹⁰B.

## Revendications

1. Procédé de fabrication de convertisseurs à neutrons, dans lequel un substrat métallique transparent pour les neutrons, en aluminium ou en un alliage d'aluminium, est, dans une première étape, poli par ponçage fin, et dans une deuxième étape, revêtu de carbure de bore par pulvérisation cathodique.

2. Procédé conforme à la revendication 1, **caractérisé en ce que** l'on effectue le ponçage fin au moyen de papiers abrasifs.

3. Procédé conforme à la revendication 2, **caractérisé en ce que** l'on utilise des papiers abrasifs de grains valant de 1000 à 2500.

4. Procédé conforme à l'une des revendications 2 et 3, **caractérisé en ce que** l'on effectue le ponçage fin en utilisant en outre un liquide de ponçage.

5. Procédé conforme à la revendication 4, **caractérisé en ce que** le liquide de ponçage est choisi dans l'ensemble constitué par de l'acétone, un alcool et de l'eau.

6. Procédé conforme à la revendication 5, **caractérisé en ce que**, en tant qu'alcool, on utilise de l'éthanol.

7. Procédé conforme à l'une des revendications précédentes, **caractérisé en ce que** le substrat métallique transparent pour les neutrons est constitué d'aluminium ou d'un alliage de titane et d'aluminium.

8. Procédé conforme à l'une des revendications précédentes, **caractérisé en ce que** l'on utilise pour le revêtement, en tant que carbure de bore, du composé de formule B₄C, enrichi en isotope ¹⁰B.

9. Procédé conforme à la revendication 7, **caractérisé en ce que** le carbure de bore contient 95 % d'isotope ¹⁰B.
